# EUROPEAN PATENT SPECIFICATION

(11) **EP 2 855 057 B1**
(45) Date of publication and mention of the grant of the patent: **13.01.2021**
(21) Application number: 13728983.1
(22) Date of filing: 24.05.2013
(51) Int. Cl.: B22F 7/08, C23C 4/12, C22C 26/00, C22C 29/08, C22C 29/06, C21D 6/00, C22C 1/05, C22C 29/16, B22F 5/00

(54) **POLYCRYSTALLINE MATERIAL, BODIES COMPRISING SAME, TOOLS COMPRISING SAME AND METHOD FOR MAKING SAME**
POLYKRISTALLINES MATERIAL, KÖRPER DAMIT, WERKZEUGE DAMIT UND VERFAHREN ZUR HERSTELLUNG DAVON
MATÉRIAU POLYCRISTALLIN, CORPS LE COMPRENANT, OUTILS LE COMPRENANT ET SON PROCÉDÉ DE FABRICATION

(30) Priority: 29.05.2012 GB 201209482; 29.05.2012 US 201261652474 P
(43) Date of publication of application: 08.04.2015
(73) Proprietor: Element Six GmbH, 36151 Burghaun (DE)
(72) Inventor: KONYASHIN, Igor, Yurievich, 36151 Burghaun (DE); RIES, Bernd, Heinrich, 36151 Burghaun (DE); LACHMANN, Frank, Friedrich, 36151 Burghaun (DE)
(74) Representative: Rollinson, Gabrielle Mary Joy
(86) International application number: PCT/EP2013/060790
(87) International publication number: WO 2013/178554

(56) References cited:
- WO-A1-2012/004292
- US-A1- 2007 243 335
- DATABASE INSPEC [Online] THE INSTITUTION OF ELECTRICAL ENGINEERS, STEVENAGE, GB; January 2011 (2011-01), KONYASHIN I YU ET AL: "Novel hardmetal with nano-strengthened binder", Database accession no. 12352854 & INORGANIC MATERIALS: APPLIED RESEARCH SPRINGER NETHERLANDS NETHERLANDS, vol. 2, no. 1, 25 March 2011 (2011-03-25), pages 19-21, ISSN: 2075-1133, DOI: 10.1134/S2075113311010102
- KONYASHIN I ET AL: "Novel ultra-coarse hardmetal grades with reinforced binder for mining and construction", INTERNATIONAL JOURNAL OF REFRACTORY METALS AND HARD MATERIALS, ELSEVIER PUBLISHERS, BARKING, GB, vol. 23, no. 4-6, 1 July 2005 (2005-07-01) , pages 225-232, XP027651150, ISSN: 0263-4368 [retrieved on 2005-07-01]

## Description

This disclosure relates generally to polycrystalline material, constructions comprising same, tools comprising same and a method for making same. In particular but not exclusively, the polycrystalline material may be for use as a hard facing material to protect bodies and tools against degradation in use.

United States patent number 7,662,207 discloses a bulk material composed of an aggregate of nano-size grains and having high strength or hardness. Crystal grains of magnetic elements such as iron, cobalt and nickel are reduced down to nano-size levels so as to provide a novel material showing improved soft magnetism. A nano-crystal austenite steel bulk material containing a solid-solution type nitrogen is disclosed. This disclosure also discussed that, as the Hall-Petch relationship teaches, metal material strength increases with decreasing crystal grain diameter D, and such strength dependency on grain diameter holds even at or near D=50 to 100 nanometres. Thus, reducing crystal grain diameters down to the ultra-fine, nano-size levels now becomes one of the most important means ever for the reinforcement of metal materials. Some technical journals suggest that reducing D down to ultra-fine sizes of as fine as a few nanometres may cause super-plasticity to occur. However, the crystal grain diameter D of most metal materials produced by melting are usually on the order of a few microns to a few tens of microns, and D can hardly be reduced down to the nano-order even by post-treatments. Even with controlled rolling, the lowest possible limit to grain diameters is of the order of at most 4 to 5 microns. According to the above mentioned disclosure, it is impossible to obtain materials whose grain diameters are reduced down to the nano-size level with ordinary processes.

International patent application publication number WO/2012/004292 discloses a body comprising a steel substrate and a hard face structure fused to the steel substrate. The hard face structure includes a plurality of micro-structures, a plurality of nano-structures having a mean size of less than about 200 nanometres, and a binder material. The nano-structures comprise more than about 20 weight per cent W, a metal M and C; M being selected from Fe, Co and Ni or an alloy thereof. The binder material comprises more than about 3 weight per cent W, more than about 2 weight per cent Cr, more than about 0.5 weight per cent Si, the metal M and C.

International patent application publication number WO2005092542 discloses a nano-crystalline high carbon iron alloy powder having high hardness, which comprises aggregates of high carbon iron nano-crystal grains, in which a material reinforcing the ferrite phase in the above nano-crystals is dispersed and precipitated. Konyashin et.al., "Novel ultra-coarse hardmetal grades with reinforced binder for mining and construction", Int. Journal of Refractory Metals and Hard Materials, Elsevier, vol. 23, no 4-6, pages 225-232, and Yu et. al., "Novel Hardmetal with Nano-Strengthened Binder" Inorganic Materials Applied Research 2011 vol. 2 no 1 pages 19-21 both describe θ-phase nano-particles in a Co-based binder.

There is a need to provide material having high wear resistance, particularly but not exclusively as a protective coating for tools or parts that may be subject to wear in use. There is also a need to provide such material having high fracture toughness.

Viewed from a first aspect there is provided polycrystalline material comprising grains of cubic boron nitride, silicon nitride or diamond, grains of carbide material, a plurality of nano-grains of a crystalline phase of an iron group element and a plurality of crystalline grains of material including carbon (C) or nitrogen (N); the iron group element being iron, the polycrystalline material further comprising at least 1 weight per cent Si, at least 5 weight per cent Cr and at least 40 weight per cent W, the balance of the polycrystalline material consisting essentially of the iron group metal and carbon, each nano-grain comprising any of austenite and ferrite, and having a mean size less than 10 nanometres; the density of the polycrystalline material being at least 98 per cent of the maximum theoretical value, the polycrystalline material comprising a contiguous aggregation of the nano-grains embedded in a binder matrix comprising a crystalline phase, the nano-grains comprised in the aggregation having respective grain boundaries between them.

Various compositions, configurations, combinations and uses are envisaged by this disclosure for polycrystalline material and for constructions and tools comprising same, and the following are non-limiting, non-exhaustive examples.

Various arrangements of the nano-grains within the polycrystalline material are envisaged. Each nano-grain may share a grain boundary with a crystalline phase comprised in the polycrystalline material, and in some examples each nano-grain may share a grain boundary with a crystalline phase of an iron group element having a mean size of at most about 50 nanometres. Each nano-grain may share a grain boundary with a crystalline phase binder material. The nano-grains may be dispersed in a binder having nano-hardness of at least about 0.9 GPa.

. The nano-grains may include at least one element in elemental or compound form, selected from B, Si, Ti, V, Cr, Mn, Zr, Nb, Mo, Hf, Ta, W, Al, Cu, Mg, K, Ca, Zn, Ag, P, S and N. The nano-grains and or the crystalline grains containing carbon and or nitrogen may, for example, contain chromium carbide, chromium oxide, tungsten carbide, silicon carbide or silica, and the compound may be in solid solution. In some examples, the nano-grains may be the crystalline grains of material including the carbon or nitrogen; the carbon and or nitrogen may be present in the nano-grains and the polycrystalline material may be substantially free of other kinds of crystalline phases containing carbon or nitrogen; the polycrystalline material may comprise carbon- and or nitrogen-containing crystalline grains other than the nano-grains; and or the nano-grains and other crystalline grains comprised in the polycrystalline material may contain carbon and or nitrogen.

The polycrystalline material may comprise boron (B).

The polycrystalline material may comprise crystalline grains of various materials and phases. In some examples, the polycrystalline material may comprise tungsten carbide (WC), titanium carbide, tantalum carbide, molybdenum carbide, niobium carbide, hafnium carbide or vanadium carbide.

In some examples, the polycrystalline material may comprise crystalline grains of compound material of the form MₓW_{y}C_{z}, where M is the iron group metal, x is a value in the range from 1 to 7, y is a value in the range from 1 to 10 and z is a value in the range from 0 to 4, the crystalline grains having a crystal structure such as that of eta-phase, theta-phase or kappa-phase carbide material.

The polycrystalline material may include a plurality of elongate or plate-like micro-structures having a mean length of at least 1 micron, a plurality of nano-structures having a mean size of less than about 200 nanometres, the micro-structures and the nano-structures being dispersed in a binder matrix; the micro-structures comprising more than 1 weight per cent Cr and a phase having the formula MₓW_{y}C_{z}, where M is the iron group metal, x is in the range from 1 to 7, y is in the range from 1 to 10 and z is in the range from 1 to 4; the nano-structures comprising the iron group metal M, C and at least about 20 weight per cent W; and the binder matrix comprises at least about 5 weight per cent W, at least about 0.5 weight per cent Cr, at least about 0.5 weight per cent Si and at least about 0.5 weight per cent carbon, the rest of the matrix being the iron group metal M. Each of the micro-structures may comprise at least a region that is plate-like, the region having two major dimensions and a minor dimension that defines the thickness, the thickness of each micro-structure being at least about 0.5 micron. Each micro-structure may comprise at least about 0.5 weight per cent Si. Each nano-structure my comprise at least about 0.3 weight per cent Si; and at least about 0.6 weight per cent Cr. The nano-structures may comprise a compound including Si, W, C and Fe. The micro-structures may be dendritic in form. The micro-structures may have a yellow or brown colour after etching in the Murakami reagent for a period in the range from about 3 seconds to about 6 seconds. The nano-structures may be the nano-grains. In some examples, the micro-structures may be the crystalline grains containing the C or N, and in some examples the nano-structures may be the nano-grains or the crystalline grains containing the C or N.

The polycrystalline material may have Vickers hardness of at least about 800 HV10; and or a Palmqvist fracture toughness of at least about 10 MPa.m^{1/2}.

Disclosed polycrystalline material may have the aspect of high hardness, high abrasive wear resistance and or high toughness. While wishing not to be bound by a particular theory, the smallness of the nano-grains being less than 10 nanometres is likely to contribute to this aspect. The nano-grains in combination with crystalline grains containing carbon or nitrogen, or the nano-grains themselves containing carbon or nitrogen may have the effect of enhancing the wear resistance of the polycrystalline material.

Viewed from a second aspect there is provided a tool comprising a structure fused to a body, the body comprising an iron group metal and the structure comprising polycrystalline material in accordance with the first aspect of the invention.The tool may be for boring into the earth and may be selected from a percussion drill bit, a rotary percussion drill bit, a rotary drill bit, a shear cutting drill bit and a roller cone drill bit. The tool may be for mining or pavement degradation, such as for road milling.

Viewed from a third aspect there is provided a method for making polycrystalline material in accordance with the first aspect of the invention, the method including providing a precursor structure comprising iron (Fe) and silicon (Si), and a source of carbon (C) or nitrogen (N), in which the relative quantities of the Fe, Si and C or N are selected such that the combination of the Fe, Si and C or N has a phase liquidus temperature of at most about 1,280 degrees; the method including heating the precursor structure to a temperature of at least about 1,350 degrees centigrade at a mean rate of at least about 100 degrees centigrade per second and cooling the precursor structure to less than about 1,000 degrees centigrade at a mean rate of at least about 20 degrees per second.

Various versions, variations and combinations are envisaged for the method by this disclosure, of which the following are non-limiting and non-exhaustive examples.

The method may include combining powder comprising the Fe and powder comprising the Si with polyvinyl compound binder material including a hydroxyl group to provide slurry; and spray drying the slurry to provide a plurality of the precursor structures in the form of granules.

The method may include providing a plurality of precursor structures and screening them to provide a plurality of screened precursor structures having mean diameter of at least 20 microns and at most 5,000 microns, at most about 1,000 microns, at most about 500 microns or at most about 200 microns, and selecting at least one of the plurality of screened precursor structures.
The method may include providing and heating the precursor structure at a temperature of at least about 300 degrees centigrade and at most about 1,300 degrees centigrade for at least about 5 minutes in a vacuum or a hydrogencontaining atmosphere or other atmosphere likely to reduce the rate of oxidation, and cooling the precursor structure to below about 300 degrees centigrade prior to heating the precursor structure to a temperature of at least about 1,350 degrees centigrade at a mean rate of at least about 100 degrees centigrade per second.

In some examples, the precursor structure may comprise Fe, Si, C and chromium (Cr), in which the relative quantities of the Fe, Si, C and Cr are selected such that the combination of the Fe, Si, C and Cr has a phase liquidus temperature of at most about 1,280 degrees centigrade.

The precursor structure may include a plurality of carbide material grains, such as WC grains, which may have mean size of at least 0.1 micron and at most 10 microns. The precursor structure may include a plurality of chromium carbide particles, and or the precursor structure may comprise super-hard material.

In some examples, the precursor structure may comprise at least about 13 weight per cent WC grains, at least 0.1 weight per cent and at most 10 weight per cent Si or Si-containing compound material, and at least 0.1 weight per cent and at most 10 weight per cent Cr or Cr-containing compound material, and the iron group metal.

In some examples, the precursor structure may comprise at least about 60 weight per cent and at most about 80 weight per cent tungsten carbide, at least about 10 weight per cent and at most about 20 weight per cent Fe, at least about 5 weight per cent chromium carbide grains, and at least about 1.0 weight per cent and at most about 5 weight per cent Si grains or grains comprising a precursor compound including Si.

The precursor structure may have compressive strength of at least 2 MPa.

The precursor structure is granular in form (i.e. the precursor structure may be a granule or pellet or such like).

The method may include combining a plurality of the precursor structures to provide a unitary structure.

In some examples, the method may include introducing boron (B) into the precursor structure, in elemental or compound form.

The method may include contacting the precursor structure with a substrate, the precursor structure being at a temperature of at least about 1,350 degrees centigrade whilst in contact with the substrate, for a sufficient period of time for the precursor structure to fuse with the substrate and provide a fused structure bonded to the substrate.

The method may include heating a plurality of the precursor structures to a temperature of at least about 1,350 degrees centigrade at a mean rate of at least about 100 degrees centigrade per second, depositing the precursor structures onto a substrate whilst at the temperature, and cooling the precursor structures to less than about 1,000 degrees centigrade at a rate of at least about 20 degrees per second.

The method may include depositing a plurality of the precursor structures onto a substrate by means of a high temperature spray apparatus; for example by means of a plasma torch, laser beam torch or flame torch.

The method may include contacting a plurality of the precursor structures with a substrate such that the precursor structures form a contiguous layer.

The method may include contacting a plurality of the precursor structures with a substrate comprising iron group metal. The substrate may comprise steel, for example.

In some examples, the method may include removing at least part of the substrate body.

There is provided a granule for use in making polycrystalline material according to this disclosure, comprising iron (Fe), silicon (Si), and polyvinyl compound binder material including a hydroxyl group; the relative quantities of the Fe and Si being selected such that a combination of the Fe and Si will have a phase liquidus temperature of at most about 1,280 degrees. The granule may comprise chromium (Cr) and carbon (C), the relative quantities of the Fe, Si, Cr and C selected such that a combination of the Fe, Si, Cr and C will have a phase liquidus temperature of at most 1,280 degrees centigrade.

The granule may comprise grains of metal carbide material such as tungsten carbide or chromium carbide. The grains of metal carbide may mean size of at least about 0.1 micron and at most about 10 microns. The granule may comprise at least about 60 weight per cent and at most about 80 weight per cent tungsten carbide grains, at least about 10 weight per cent and at most about 20 weight per cent iron (Fe) grains, at least about 5 weight per cent chromium carbide grains, and at least about 1 weight per cent and at most about 5 weight per cent silicon (Si) grains. Each granule may comprise at least one grain of super-hard material such as diamond or cBN material.

The granule may have mean diameter of at least about 20 microns and at most about 5,000 microns, at most about 1,000 microns, at most about 500 microns or at most about 200 microns.

The granule may have compressive strength of at least about 2 MPa.

Disclosed example methods may have the aspect of resulting in a very effective hard face structure intimately welded onto the body, and disclosed bodies may have improved wear retardation behaviour in use.

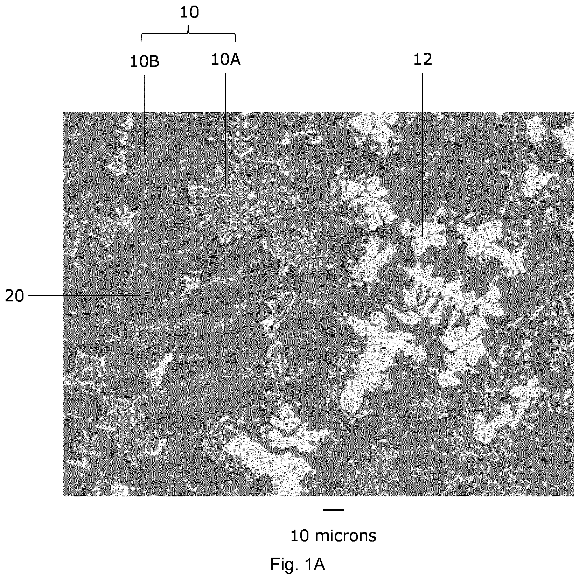

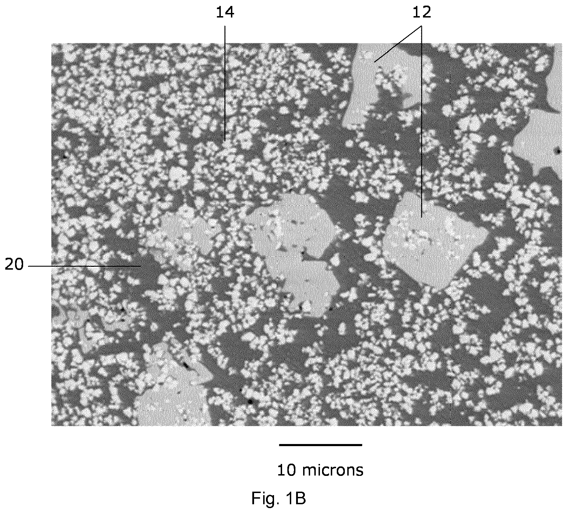

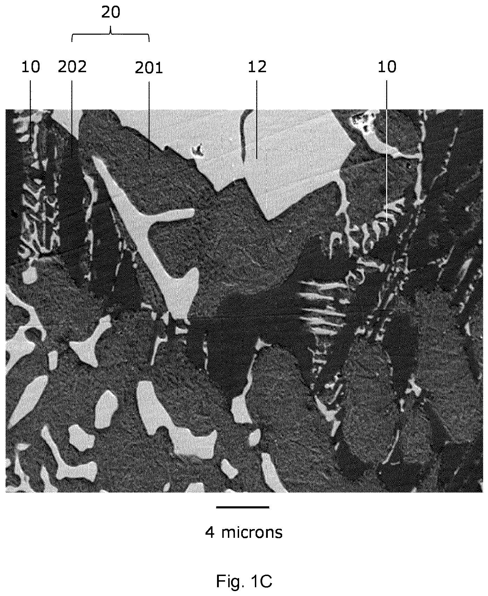

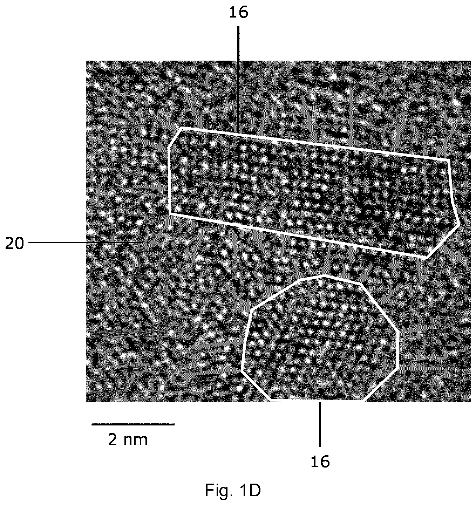

Non-limiting example arrangements will now be described with reference to the accompanying drawings, of which
Fig. 1A shows a 500X magnification scanning electron micrographs (SEM) of example polycrystalline material, Fig. 1B shows a 2,000X magnification SEM image of example polycrystalline material, Fig. 1C shows a 4,000X magnification SEM image of example polycrystalline material; and Fig. 1D shows a high resolution transmission electron microscopic (HRTEM) image of the example polycrystalline material, in which nano-grains are indicated by means of a white outline superimposed on the image;

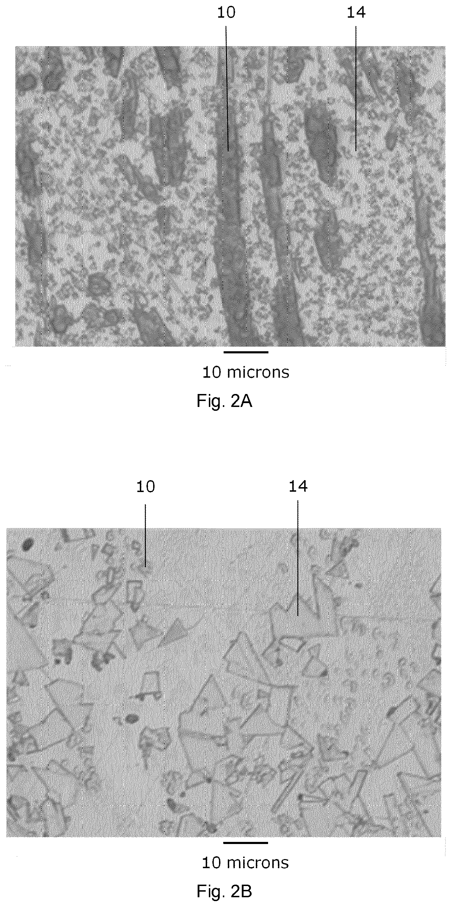

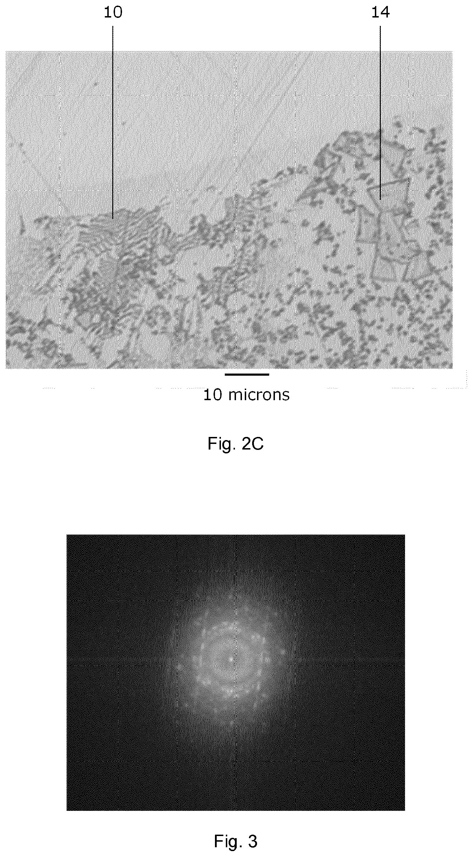

Fig. 2A, Fig. 2B and Fig. 2C show microstructures of example polycrystalline material in the form of a layer structure fused to a steel substrate, the polycrystalline material having been etched in Murakami reagent for 4 minutes (light microscopy), of which
Fig. 2A shows an image of a region proximate the surface of the layer structure, Fig. 2B shows an image of the polycrystalline material etched to a depth of 1.5 millimetres from the surface of the layer structure and Fig. 2C shows an image of the interface with the steel substrate;
Fig. 3 shows an electron diffraction image of example polycrystalline material;
Fig. 4A and Fig. 4B show transmission electron microscopic (TEM) images of example polycrystalline material;
Fig. 5 shows a schematic perspective view of an example pick tool for mining; and
Fig. 6 shows a schematic side view of an example super-hard pick tool for road milling.

An example method for making example polycrystalline material in the form of a layer structure fused to a steel substrate is described below.

A powder blend having a mass of 100 kg was prepared, comprising 72.7 weight per cent tungsten carbide (WC) powder having mean particle size of 1 micron, 15 weight per cent iron (Fe) powder, 10 weight per cent chromium carbide (Cr3C2) powder and 2.3 weight per cent silicon (Si) powder. The powder blend was milled for about one hour in an attritor mill in water medium using 600 kilograms hard-metal balls and 4 kilograms organic binder based of polyvinyl-containing hydroxyl groups (product KM4034, Szchimmer and Scharz™) to provide a slurry. After milling, the slurry was spray-dried to provide granules which were screened to obtain select granules from about 100 microns to about 180 microns.

The mean compressive strength of the granules was measured selecting a plurality of the granules at random, measuring the diameter of each and compressing each between two steel plates at forces from 0.1 milli-Newtons to 900 milli-Newtons (for example, by means of an instrument of the etewe™ GmbH company in Germany). The relationship between the degree of diametric deformation of each grain and the applied forces was measured, and the compressive strength of each grain was calculated on the basis of this measured relationship. The compressive strength of the granules was found to be in the range from about 2 mega-Pascals to about 10 mega-Pascals.

A steel substrate was provided and the granules were sprayed onto the substrate by means of a plasma torch apparatus (Plasmastar™) for atmospheric plasma spraying, operated at a current of 100 Amperes in an Ar gas flow. In the process of spraying, the granules were heated at a rate of about 300 degrees centigrade per second to a temperature about 1,400 degrees centigrade. The subsequent cooling rate was about 40 degrees centigrade per second. A contiguous layer formed from the granules was thus provided fused to the substrate, the density of the layer being close to the theoretical density and the mean thickness of the layer being about 3 millimetres. The steel substrates thus coated were heat-treated.

The Vickers HV10 hardness of the polycrystalline material layer was found to be 1,000 Vickers units and the Palmqvist fracture toughness to be 15 MPa.m^{1/2}. The Vickers hardness was measured according to the ISO standard ISO 3878 and the Palmqvist fracture toughness was measured according to the ISO standard ISO/DIS 20079. The coated steel substrates were tested by use of the ASTM G65-04 test to measure wear resistance, with uncoated steel substrates being used as controls. The mass loss due to abrasion of the control was about 820 milligrams and that of the coated steel substrate was about 80 milligrams, and the volume loss of the uncoated steel was 105.2 cubic millimetres and that of the coated steel was 6.5 cubic millimetres. This indicates that the wear resistance of the example polycrystalline material was more than 15 times higher than that of the steel substrate.

Non-limiting, example polycrystalline material provided as described above will now be described.

Images of the microstructure of the example polycrystalline material are shown in Fig. 1A, Fig. 1B, Fig. 1C and Fig. 1D at various magnifications. The material includes plate-like dendritic or rounded crystallite structures 10 and eta-phase carbide crystallites 12 dispersed in binder matrix 20.

The nano-hardness of the binder matrix 20 was found to be from about 1.0 GPa to about 1.3 GPa. The nano-hardness is measured by means of a TriboIndenter™ instrument (Hysitron Inc., Minneapolis, MN, USA) with a Berkovich tip, using maximum loads of 500 micro-N and 2 mN. The loading schedule involved 10 seconds linear loading, 10 seconds hold at constant load, and 10 seconds linear unloading.

In Fig. 1A, the dendritic structure of the crystallite structures 10 is evident in some instances 10A, while the plate-like or flat aspect of the crystallite structures 10 is evident in other instances 10B that are pictured side-on.

Tungsten carbide (WC) grains 14 dispersed in the binder matrix 20 are evident in Fig. 1B.

Fig. 1C shows an electron back-scatter image of the polycrystalline material after removal of a surface layer of about 5 nanometres by means of Ar etching. The compositions of the various micro-structures and materials evident in Fig. 1C were examined by Auger electron spectroscopy (AES). The binder material 20 within which the dendritic crystallites 10, eta-phase crystallites 12 and WC crystallites 14 are embedded comprises two spatially distinct components in distinct regions 201, 202, which are evident as different shades of grey in Fig. 1C. The binder material of the first region 201 includes a plurality of the nano-grains of a crystalline phase of iron. The material of the first region 201 comprises about 24.8 weight per cent W, 65.7 weight per cent Fe, 3.5 weight per cent Cr, 4.3 weight per cent C and 1.7 weight per cent Si. The binder material of the second region 202 is substantially free of the nano-grains and comprises about 29.8 weight per cent W, 57.8 weight per cent Fe, 4.9 weight per cent Cr, 6.9 weight per cent C and 0.6 weight per cent Si. The dendritic structures 10 comprise about 62.4 weight per cent W, 30.7 weight per cent Fe, 1.8 weight per cent Cr, weight per cent C and 1.6 weight per cent Si.

Fig. 1D shows an high resolution TEM (HRTEM) image of the binder material 20 within the first region 201, in which nano-grains 16 dispersed therein are evident. The nano-grains 16 are indicated by white boundary lines and have a mean size in the range from about 2 nanometres to about 10 nanometres. At least some of the grains 16 appear to be generally elongate and have a mean length of about 7 nanometres and mean width of about 4 nanometres. X-ray diffraction and electron diffraction indicate that the nano-grains 16 comprise crystalline phases of iron, including Fe₃W₃C, ferrite and austenite.

With reference to Fig. 2A, Fig. 2B and Fig. 2C, the dendritic crystallites 10 appear brown in colour after etching in Murakami reagent for about 5 seconds. The dendritic crystallites 10 comprise eta-phase carbide. Some of the dendritic crystallites 10 become black and some remain brown after further etching in the Murakami reagent for about 4 minutes WC crystallite grains 14 are also evident in example polycrystalline material.

The electron diffraction image shown in Fig. 3 indicates that the binder matrix has a nano-crystalline structure with very little amorphous phase present.

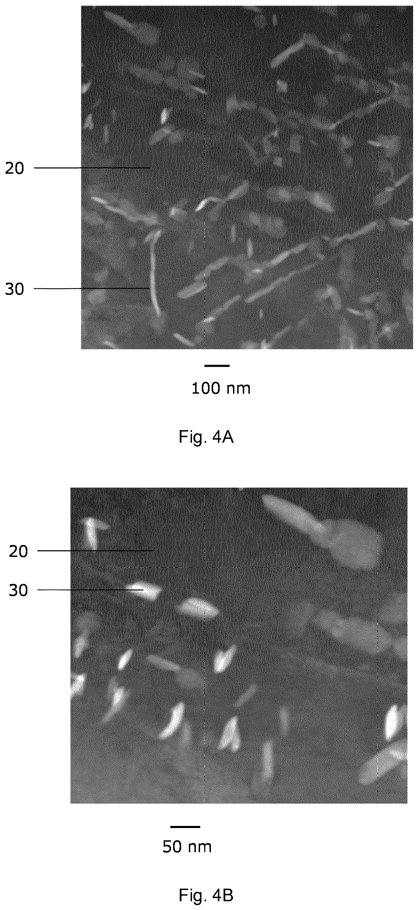

As shown in Fig. 4A and Fig. 4B, transmission electron microscopy (TEM) indicates the presence of nano-sized grains 30 of eta-phase carbide in the binder matrix 20, having the general form of nano-plates, nano-rods or nano-spheres, which are embedded in the binder matrix 20.

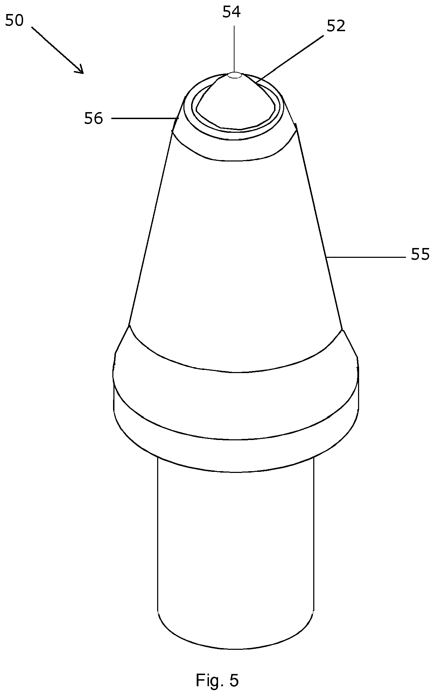

With reference to Fig 5, an example pick tool 50 for mining comprises a steel base 55 and a hard face structure 56 fused to the steel substrate 55. The pick tool 50 comprises a cemented carbide tip 52 having a strike point 54 and joined to the steel base 55. In some examples the tip 52 may comprise diamond material such as PCD material or silicon carbide-bonded diamond material. The hard face structure 56 is arranged around the cemented carbide tip 52 to protect the steel substrate 55 from abrasive wear in use. In use breaking up a rock formation comprising coal or potash, for example, rock material may abrade the steel base 55 leading to premature failure of the pick tool 50. The hard face structure 56 comprises or consists essentially of example polycrystalline material according to this disclosure.

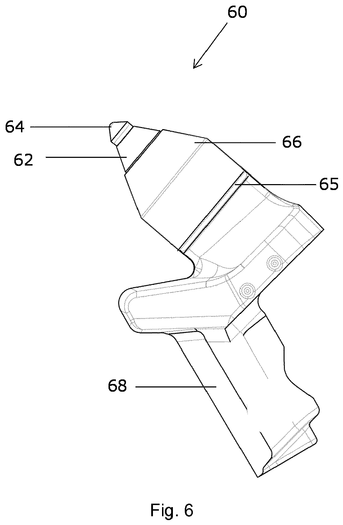

With reference to Fig. 6, an example pick tool 60 for a road pavement milling comprises a steel holder 65 provided with a bore, and a strike tip 64 joined to a cemented carbide base 62 that is shrink fit or press fit into the bore. A hard face structure 66 comprising polycrystalline material according to this disclosure is fused to the steel holder 65, arranged around the bore to protect the steel holder body 65 from wear in use. The strike tip 64 may comprise a PCD structure joined to a cemented tungsten carbide substrate. The holder 65 comprises a shank 68 for coupling to a base block (not shown) attached to a road milling drum (not shown).

As used herein in relation to grains comprised in polycrystalline material, the term "grain size" d refers to the sizes of the grains measured as follows. A surface of a body comprising the hard-metal material is prepared by polishing for investigation by means of electron backscatter diffraction (EBSD) and EBSD images of the surface are obtained by means of a high-resolution scanning electron microscope (HRSEM). Images of the surface in which the individual grains can be discerned are produced by this method and can be further analysed to provide the number distribution of the sizes d of the grains, for example. As used herein, no correction (e.g. Saltykov correction) is applied to correct the grain sizes to account for the fact that they were obtained from a two dimensional image in this way. The grain size is expressed in terms of equivalent circle diameter (ECD) according to the ISO FDIS 13067 standard. The ECD is obtained by measuring of the area A of individual grains exposed at the surface and calculating the diameter of a circle that would have the same area A, according to the equation d = square root of (4 X A / π). The method is described further in section 3.3.2 of ISO FDIS 13067 entitled "Microbeam analysis - Electron Backscatter Diffraction - Measurement of average grain size" (International Standards Organisation, Geneva, Switzerland, 2011). The mean grain size D of WC grains in cemented WC material is obtained by calculating the number average of the WC grain sizes d as obtained from the EBSD images of the surface. The EBSD method of measuring the sizes of the grains has the significant advantage that each individual grain can be discerned, in contrast to certain other methods in which it may be difficult or impossible to discern individual grains from agglomerations of grains. In other words, certain other methods may be likely to give false higher values for grain size measurements.

Certain terms and concepts as used herein are briefly explained below.

As used herein, a hard face structure is a structure such as, but not limited to, a layer joined to a substrate to protect the substrate from wear. The hard face structure exhibits a substantially greater wear resistance than does the substrate.

As used herein, a wear part is a part or component that is subjected, or intended to be subjected to wearing stress in application. There are various kinds of wearing stress to which wear parts may typically be subjected such as abrasion, erosion, corrosion and other forms of chemical wear. Wear parts may comprise any of a wide variety of materials, depending on the nature and intensity of wear that the wear part is expected to endure and constraints of cost, size and mass. For example, cemented tungsten carbide is highly resistant to abrasion but due to its high density and cost is typically used only as the primary constituent of relatively small parts, such as drill bit inserts, chisels, cutting tips and the like. Larger wear parts may be used in excavation, drill bit bodies, hoppers and carriers of abrasive materials and are typically made of hard steels which are much more economical than cemented carbides in certain applications.

Pick tools may be used for breaking, degrading or boring into bodies, such as rock, asphalt, coal or concrete, for example, and may be used in applications such as mining, construction and road reconditioning. In some applications, for example road reconditioning, a plurality of pick tools may be mounted on a rotatable drum and driven against the body to be degraded as the drum is rotated against the body. Pick tools may comprise a working tip of a super-hard material, for example polycrystalline diamond (PCD), which comprises a mass of substantially inter-grown diamond grains forming a skeletal mass defining interstices between the diamond grains.

Synthetic and natural diamond, polycrystalline diamond (PCD), cubic boron nitride (cBN), polycrystalline cBN (PCBN) and silicon carbide bonded diamond (ScD) material are examples of super-hard materials. As used herein, synthetic diamond, which is also called man-made diamond, is diamond material that has been manufactured. As used herein, polycrystalline diamond (PCD) material comprises a mass (an aggregation of a plurality) of diamond grains, a substantial portion of which are directly inter-bonded with each other and in which the content of diamond is at least about 80 volume per cent of the material. Interstices between the diamond grains may be at least partly filled with a binder material comprising a catalyst material for synthetic diamond, or they may be substantially empty. As used herein, a catalyst material for synthetic diamond is capable of promoting the growth of synthetic diamond grains and or the direct inter-growth of synthetic or natural diamond grains at a temperature and pressure at which synthetic or natural diamond is thermodynamically stable. Examples of catalyst materials for diamond are Fe, Ni, Co and Mn, and certain alloys including these. Bodies comprising PCD material may comprise at least a region from which catalyst material has been removed from the interstices, leaving interstitial voids between the diamond grains. As used herein, PCBN material comprises grains of cubic boron nitride (cBN) dispersed within a matrix comprising metal or ceramic material.

Other examples of superhard materials include certain composite materials comprising diamond or cBN grains held together by a matrix comprising ceramic material, such as silicon carbide (SiC), or cemented carbide material, such as Co-bonded WC material (for example, as described in United States patents numbers 5,453,105 or 6,919,040). For example, certain SiC-bonded diamond materials may comprise at least about 30 volume per cent diamond grains dispersed in a SiC matrix (which may contain a minor amount of Si in a form other than SiC). Examples of SiC-bonded diamond materials are described in United States patents numbers 7,008,672; 6,709,747; 6,179,886; 6,447,852; and International Application publication number WO2009/013713).

A grain boundary is the interface between two grains, or crystallites, in a polycrystalline material. Grain boundaries are defects in the crystal structure, and tend to decrease the electrical and thermal conductivity of the material.

Several phases comprising tungsten (W), cobalt (Co) and carbon (C) are known and are typically designated by Greek letters. An eta-phase composition is understood herein to mean a carbide compound having the general formula Mx M'y C2, where M is at least one element selected from the group consisting of W, Mo, Ti, Cr, V, Ta, Hf, Zr, and Nb; M' is at least one element selected from the group consisting of Fe, Co, Ni, and C is carbon. Where M is tungsten (W) and M' is cobalt (Co), as is the most typical combination, then eta-phase is understood herein to mean C03W3C (eta-1) or Co6WeC (eta-2), as well as fractional sub- and super-stochiometric variations thereof. There are also some other phases in the W-Co-C system, such as theta-phases C03W6C2, Co4W4C and Co2W4C, as well as kappa-phases Co3WgC4 and CoW3C (these phases are sometimes grouped in the literature within a broader designation of eta-phase).

As used herein, the phase "consists essentially of" means "consist of, apart from practically unavoidable impurities".

## Claims

1. Polycrystalline material comprising grains of cubic boron nitride, silicon nitride or diamond, grains of carbide material, a plurality of nano-grains of a crystalline phase of an iron group element and a plurality of crystalline grains of material including carbon (C) or nitrogen (N); the iron group element being iron, the polycrystalline material further comprising at least 1 weight per cent Si, at least 5 weight per cent Cr and at least 40 weight per cent W, the balance of the polycrystalline material consisting essentially of the iron group metal and carbon, each nano-grain comprising any of austenite and ferrite, and having a mean size less than 10 nanometres; the density of the polycrystalline material being at least 98 per cent of the maximum theoretical value, the polycrystalline material comprising a contiguous aggregation of the nano-grains embedded in a binder matrix comprising a crystalline phase, the nano-grains comprised in the aggregation having respective grain boundaries between them.

2. Polycrystalline material as claimed in claim 1, in which each nano-grain shares a grain boundary with a crystalline phase comprised in the polycrystalline material.

3. Polycrystalline material as claimed in claim 1 or 2, in which each nano-grain shares a grain boundary with a crystalline phase of the iron group element having a mean size of at most 50 nanometres.

4. Polycrystalline material as claimed in any of the preceding claims, in which the nano-grains are the crystalline grains of material including the C or N.

5. Polycrystalline material as claimed in any of the preceding claims, in which the grains of carbide material are tungsten carbide (WC), titanium carbide, tantalum carbide, molybdenum carbide, niobium carbide, hafnium carbide or vanadium carbide.

6. A tool comprising a structure fused to a body, the body comprising an iron group metal and the structure comprising polycrystalline material as claimed in any of claims 1 to 5.

7. A method for making polycrystalline material comprising grains of cubic boron nitride, silicon nitride or diamond, grains of carbide material, a plurality of nano-grains of a crystalline phase of an iron group element and a plurality of crystalline grains of material including carbon (C) or nitrogen (N); the iron group element being iron, the polycrystalline material further comprising at least 1 weight per cent Si, at least 5 weight per cent Cr and at least 40 weight per cent W, the balance of the polycrystalline material consisting essentially of the iron group metal and carbon, each nano-grain comprising any of austenite and ferrite, and having a mean size less than 10 nanometres; the density of the polycrystalline material being at least 98 per cent of the maximum theoretical value, the polycrystalline material comprising a contiguous aggregation of the nano-grains embedded in a binder matrix comprising a crystalline phase, the nano-grains comprised in the aggregation having respective grain boundaries between them, the method including providing a precursor structure comprising iron (Fe) and silicon (Si), and a source of carbon (C) or nitrogen (N), in which the relative quantities of the Fe, Si and C or N are selected such that the combination of the Fe, Si and C or N has a phase liquidus temperature of at most 1,280 degrees centigrade; the method including heating the precursor structure to a temperature of at least 1,350 degrees centigrade at a mean rate of at least 100 degrees centigrade per second and cooling the precursor structure to less than 1,000 degrees centigrade at a mean rate of at least 20 degrees per second.

8. A method as claimed in claim 7 in which the precursor structure comprises Fe, Si, C and chromium (Cr), in which the relative quantities of the Fe, Si, C and Cr are selected such that the combination of the Fe, Si, C and Cr has a phase liquidus temperature of at most 1,280 degrees centigrade.

9. A method as claimed in claim 7 or claim 8, including heating a plurality of the precursor structures in granular form to a temperature of at least 1,350 degrees centigrade at a mean rate of at least 100 degrees centigrade per second, depositing the precursor structures onto a substrate while at the temperature, and cooling the precursor structures to less than 1,000 degrees centigrade at a rate of at least 20 degrees per second.

10. A method as claimed in ay of claims 7 to 9, including depositing a plurality of the precursor structures onto a substrate by means of a plasma torch, laser beam torch or flame torch.

## Patentansprüche

1. Polykristallines Material, umfassend Körner aus kubischem Bornitrid, Siliciumnitrid oder Diamant, Körner aus Carbidmaterial, mehrere Nanokörner einer kristallinen Phase eines Elements der Eisengruppe und mehrere kristalline Körner eines Materials, das Kohlenstoff (C) oder Stickstoff (N) beinhaltet; wobei das Element der Eisengruppe Eisen ist, wobei das polykristalline Material ferner mindestens 1 Gewichtsprozent Si, mindestens 5 Gewichtsprozent Cr und mindestens 40 Gewichtsprozent W umfasst, wobei der Rest des polykristallinen Materials im Wesentlichen aus dem Metall der Eisengruppe und Kohlenstoff besteht, wobei jedes Nanokorn einen/eines von Austenit und Ferrit umfasst und eine mittlere Größe von weniger als 10 Nanometern aufweist; wobei die Dichte des polykristallinen Materials mindestens 98 Prozent des maximalen theoretischen Werts beträgt, wobei das polykristalline Material eine aneinandergrenzende Aggregation der Nanokörner umfasst, die in eine Bindemittel-Matrix, die eine kristalline Phase umfasst, eingebettet sind, wobei die Nanokörner, die in der Aggregation enthalten sind, jeweils Korngrenzen zwischen sich aufweisen.

2. Polykristallines Material wie in Anspruch 1 beansprucht, wobei sich jedes Nanokorn eine Korngrenze mit einer kristallinen Phase teilt, die in dem polykristallinen Material enthalten ist.

3. Polykristallines Material wie in Anspruch 1 oder 2 beansprucht, wobei sich jedes Nanokorn eine Korngrenze mit einer kristallinen Phase des Elements der Eisengruppe mit einer mittleren Größe von höchstens 50 Nanometern teilt.

4. Polykristallines Material wie in einem der vorhergehenden Ansprüche beansprucht, wobei die Nanokörner die kristallinen Körner des Materials sind, das das C oder N beinhaltet.

5. Polykristallines Material wie in einem der vorhergehenden Ansprüche beansprucht, wobei die Körner des Carbidmaterials Wolframcarbid (WC), Titancarbid, Tantalcarbid, Molybdäncarbid, Niobcarbid, Hafniumcarbid oder Vanadiumcarbid sind.

6. Ein Werkzeug, umfassend eine an einen Körper geschmolzene Struktur, wobei der Körper ein Metall der Eisengruppe umfasst und die Struktur polykristallines Material wie in einem der Ansprüche 1 bis 5 beansprucht umfasst.

7. Ein Verfahren zu Herstellung eines polykristallinen Materials, umfassend Körner aus kubischem Bornitrid, Siliciumnitrid oder Diamant, Körner aus Carbidmaterial, mehrere Nanokörner einer kristallinen Phase eines Elements der Eisengruppe und mehrere kristalline Körner eines Materials, das Kohlenstoff (C) oder Stickstoff (N) beinhaltet; wobei das Element der Eisengruppe Eisen ist, wobei das polykristalline Material ferner mindestens 1 Gewichtsprozent Si, mindestens 5 Gewichtsprozent Cr und mindestens 40 Gewichtsprozent W umfasst, wobei der Rest des polykristallinen Materials im Wesentlichen aus dem Metall der Eisengruppe und Kohlenstoff besteht, wobei jedes Nanokorn einen/eines aus Austenit und Ferrit umfasst und eine mittlere Größe von weniger als 10 Nanometern aufweist; wobei die Dichte des polykristallinen Materials mindestens 98 Prozent des maximalen theoretischen Werts beträgt, wobei das polykristalline Material eine aneinandergrenzende Aggregation der Nanokörner umfasst, die in eine Bindemittel-Matrix, die eine kristalline Phase umfasst, eingebettet sind, wobei die Nanokörner, die in der Aggregation enthalten sind, jeweils Korngrenzen zwischen sich aufweisen, wobei das Verfahren das Bereitstellen einer Vorläufer-Struktur, umfassend Eisen (Fe) und Silicium (Si), und einer Kohlenstoff- (C) oder Stickstoffquelle (N) beinhaltet, wobei die relativen Mengen des Fe, Si und C oder N derart ausgewählt sind, dass die Kombination des Fe, Si und C oder N eine Phasen-Liquidustemperatur von höchstens 1.280 Grad Celsius aufweist; wobei das Verfahren das Erwärmen der Vorläufer-Struktur auf eine Temperatur von mindestens 1.350 Grad Celsius bei einer mittleren Geschwindigkeit von mindestens 100 Grad Celsius pro Sekunde und das Abkühlen der Vorläuferstruktur auf weniger als 1.000 Grad Celsius bei einer mittleren Geschwindigkeit von mindestens 20 Grad Celsius pro Sekunde beinhaltet.

8. Ein Verfahren wie in Anspruch 7 beansprucht, wobei die Vorläufer-Struktur Fe, Si, C und Chrom (Cr) umfasst, wobei die relativen Mengen des Fe, Si, C und Cr derart ausgewählt sind, dass die Kombination des Fe, Si, C und Cr eine Phasen-Liquidustemperatur von höchstens 1.280 Grad Celsius aufweist.

9. Ein Verfahren wie in Anspruch 7 oder Anspruch 8 beansprucht, das das Erwärmen von mehreren der Vorläufer-Strukturen in körniger Form auf eine Temperatur von mindestens 1.350 Grad Celsius bei einer mittleren Geschwindigkeit von mindestens 100 Grad Celsius pro Sekunde, Aufbringen der Vorläufer-Strukturen auf einen Träger bei dieser Temperatur und Abkühlen der Vorläufer-Strukturen auf weniger als 1.000 Grad Celsius bei einer Geschwindigkeit von mindestens 20 Grad pro Sekunde beinhaltet.

10. Ein Verfahren, wie in einem der Ansprüche 7 bis 9 beansprucht, das das Aufbringen von mehreren der Vorläufer-Strukturen auf einen Träger unter Verwendung eines Plasmabrenners, Laserstrahlbrenners oder Flammenbrenners beinhaltet.

## Revendications

1. Matériau polycristallin comprenant des grains de nitrure de bore cubique, de nitrure de silicium ou de diamant, des grains de matériau de type carbure, une pluralité de nano-grains d'une phase cristalline d'un élément du groupe du fer et une pluralité de grains cristallins d'un matériau contenant du carbone (C) ou de l'azote (N) ; l'élément du groupe du fer étant le fer, le matériau polycristallin comprenant en outre au moins 1 % en poids de Si, au moins 5 % en poids de Cr et au moins 40 % en poids de W, le reste du matériau polycristallin consistant essentiellement en le métal du groupe du fer et en carbone, chaque nano-grain comprenant l'une quelconque parmi l'austénite et la ferrite, et ayant une taille moyenne inférieure à 10 nanomètres ; la densité du matériau polycristallin étant d'au moins 98 % de la valeur théorique maximale, le matériau polycristallin comprenant une agrégation continue des nano-grains incorporés dans une matrice liante comprenant une phase cristalline, les nano-grains compris dans l'agrégation ayant des joints de grains respectifs entre eux.

2. Matériau polycristallin selon la revendication 1, dans lequel chaque nano-grain partage un joint de grains avec une phase cristalline comprise dans le matériau polycristallin.

3. Matériau polycristallin selon la revendication 1 ou 2, dans lequel chaque nano-grain partage un joint de grains avec une phase cristalline de l'élément du groupe du fer ayant une taille moyenne d'au plus 50 nanomètres.

4. Matériau polycristallin selon l'une quelconque des revendications précédentes, dans lequel les nano-grains sont les grains cristallins de matériau contenant C ou N.

5. Matériau polycristallin selon l'une quelconque des revendications précédentes, dans lequel les grains du matériau de type carbure sont en carbure de tungstène (WC), carbure de titane, carbure de tantale, carbure de molybdène, carbure de niobium, carbure de hafnium ou carbure de vanadium.

6. Outil comprenant une structure fusionnée à un corps, le corps comprenant un métal du groupe du fer et la structure comprenant le matériau polycristallin de l'une quelconque des revendications 1 à 5.

7. Procédé de production d'un matériau polycristallin comprenant des grains de nitrure de bore cubique, de nitrure de silicium ou de diamant, des grains de matériau de type carbure, une pluralité de nano-grains d'une phase cristalline d'un élément du groupe du fer et une pluralité de grains cristallins d'un matériau contenant du carbone (C) ou de l'azote (N) ; l'élément du groupe du fer étant le fer, le matériau polycristallin comprenant en outre au moins 1 % en poids de Si, au moins 5 % en poids de Cr et au moins 40 % en poids de W, le reste du matériau polycristallin consistant essentiellement en le métal du groupe du fer et en carbone, chaque nano-grain comprenant l'une quelconque parmi l'austénite et la ferrite, et ayant une taille moyenne inférieure à 10 nanomètres ; la densité du matériau polycristallin étant d'au moins 98 % de la valeur théorique maximale, le matériau polycristallin comprenant une agrégation continue des nano-grains incorporés dans une matrice liante comprenant une phase cristalline, les nano-grains compris dans l'agrégation ayant des joints de grains respectifs entre eux, le procédé comprenant l'obtention d'une structure de précurseur comprenant du fer (Fe) et du silicium (Si), et d'une source de carbone (C) ou d'azote (N), dans laquelle les quantités relatives des Fe, Si et C ou N sont choisies de façon que la combinaison des Fe, Si et C ou N ait une température de liquidus de phase d'au plus 1 280 °C ; le procédé comprenant le chauffage de la structure de précurseur à une température d'au moins 1 350°C à une vitesse moyenne d'au moins 100°C par seconde, et le refroidissement de la structure de précurseur à moins de 1 000°C à une vitesse moyenne d'au moins 20 degrés par seconde.

8. Procédé selon la revendication 7, dans lequel la structure de précurseur comprend Fe, Si, C et du chrome (Cr), dans laquelle les quantités relatives des Fe, Si, C et Cr sont choisies de façon que la combinaison des Fe, Si, C et Cr ait une température de liquidus de phase d'au plus 1 280°C.

9. Procédé selon la revendication 7 ou la revendication 8, comprenant le chauffage d'une pluralité des structures de précurseur sous forme granulaire à une température d'au moins 1 350°C à une vitesse moyenne d'au moins 100°C par seconde, le dépôt des structures de précurseur sur un substrat pendant qu'elles sont à la température en question, et le refroidissement des structures de précurseur à moins de 1 000°C à une vitesse d'au moins 20 degrés par seconde.

10. Procédé selon l'une quelconque des revendications 7 à 9, comprenant le dépôt d'une pluralité des structures de précurseur sur un substrat au moyen d'une torche à plasma, d'une torche à faisceau laser ou d'une torche à flamme.
